# EUROPEAN PATENT SPECIFICATION

(11) **EP 3 370 038 B1**
(45) Date of publication and mention of the grant of the patent: **17.06.2020**
(21) Application number: 16859388.7
(22) Date of filing: 26.08.2016
(51) Int. Cl.: G01D 3/036, G01D 5/14, G01D 5/18, G01R 33/02, G01R 33/09, G01B 5/00, G01B 7/00

(54) **POSITION DETECTION DEVICE**
POSITIONSERKENNUNGSVORRICHTUNG
DISPOSITIF DE DÉTECTION DE POSITION

(30) Priority: 28.10.2015 JP 2015211556
(43) Date of publication of application: 05.09.2018
(73) Proprietor: Alps Alpine Co., Ltd., Tokyo 145-8501 (JP)
(72) Inventor: YASUDA, Yukiko, Tokyo 145-8501 (JP); TOKUNAGA, Ichiro, Tokyo 145-8501 (JP); SAITO, Taku, Tokyo 145-8501 (JP)
(74) Representative: Schmitt-Nilson Schraud Waibel Wohlfrom Patentanwälte Partnerschaft mbB
(86) International application number: PCT/JP2016/074941
(87) International publication number: WO 2017/073151

(56) References cited:
- JP-A- 2001 050 703
- JP-A- 2007 132 710
- JP-A- 2010 197 373
- US-A1- 2003 112 006
- US-A1- 2003 137 292
- US-A1- 2010 188 074
- US-B1- 7 088 095
- US-B1- 7 088 095

## Description

### Technical Field

The present invention relates to a position detection device that detects the relative positions and movement of a magnet and a detection unit having a magnetic sensor.

### Background Art

PTL 1 describes an invention relating to a position detection device.

The position detection device has a case accommodating a holder that moves to advance and retreat, and the holder is provided with two magnets that are arranged side by side in a moving direction. A detection unit is fixed to the case. The detection unit is provided with two magnetoresistive elements facing the magnets that move.

The holder is urged by a compression coil spring in a direction in which the holder projects from the case. When a shaft integrally formed with the holder is pressed to move the case in a direction against the urging direction of the compression coil spring, the movement of the magnets is detected with the magnetoresistive elements and the moving position of the holder is calculated.

### Citation List

### Patent Literature

PTL 1: Japanese Registered Utility Model No. 3191531

US 2010/188074 A1 discloses a stroke sensor which has two magnets which are magnetized in a cross-section direction and are displaced in a longitudinal direction, and two magnetism sensitive sections arranged parallel to the longitudinal direction. The magnets have circular-arc-shaped swelling end edges respectively and are magnetized such that the swelling end edges have opposite polarities. Thus, a distribution of a magnetic flux density on an arrangement axis substantially coincides with a sine curve. The magnetic flux having such the distribution is displaced in the longitudinal direction together with the magnets. The magnetism sensitive sections are arranged on the arrangement axis to be distant from each other by a distance of one fourth of a cycle of the sine curve.

The present invention relates to a position detection device according to the appended claims.

### Summary of Invention

### Technical Problem

Although PTL 1 does not provide a detailed description of a method for detecting the position of the holder, in a typical position detection device of this type, the magnetoresistive elements detect a component (Bz) and a component (Bx) of the magnetic flux density of a leakage magnetic field generated by the two magnets, the component (Bz) being in a direction perpendicular to the direction in which the holder moves, the component (Bx) being in a direction parallel to the direction in which the holder moves, to calculate the moving position of the holder. For example, an arc tangent is computed from the detected value of the component (Bz) and the detected value of the component (Bx), and the position of the holder is determined from the computed value.

Here, the intensity of the leakage magnetic field from the magnets is affected by temperature, and a demagnetization phenomenon in which the magnetic flux density of the leakage magnetic field decreases occurs at a high temperature. It is conventionally recognized that the rate at which the magnetic flux density decreases when a rectangular parallelepiped magnet is heated is always in the same proportion for the component (Bz) in the direction perpendicular to a magnetized surface and the component (Bx) in the direction parallel to the magnetized surface.

On the basis of this recognition, it is considered that an arc tangent is computed on the basis of detected values obtained from the magnetoresistive elements at room temperature and a correction is made on a circuit so as to ensure linearity in the computed value, which makes it possible to ensure linearity of computed values when the holder is moved even if a temperature change occurs.

In an actual position detection device, however, a problem arises in that, in a high-temperature environment, the value of the arc tangent computed on the basis of the output from the detection unit varies in accordance with a change in position facing the magnetized surfaces of the magnets and it is difficult to ensure linear position detection.

The present invention is intended to address the conventional problem described above, and it is an object of the present invention to provide a position detection device having a structure that makes it easy to ensure the linearity of detection values for detecting the relative movement of a magnet and a detection unit even when a temperature change causes demagnetization of the magnet.

### Solution to Problem

The present invention provides a position detection device including a detection unit and a magnet facing the detection unit, the detection unit and the magnet being movable relatively to each other,
wherein the magnet is magnetized in a direction perpendicular to a relative movement trajectory of the detection unit, and the detection unit includes a magnetic sensor that detects a component of magnetic flux emerging from the magnet that is parallel to the movement trajectory, and a magnetic sensor that detects a component of the magnetic flux that is perpendicular to the movement trajectory, and
wherein the magnet has a facing surface facing the movement trajectory, and both ends of the facing surface in a direction extending along the movement trajectory are positioned farther away from the movement trajectory than a center portion of the facing surface.

In the position detection device according to the present invention, for example, the facing surface is a projecting curved surface having a curvature in a direction extending along the movement trajectory.

In this case, preferably, the curvature has a radius that is greater than or equal to 1.7 times and less than or equal to 3.4 times a shortest distance between the facing surface and the movement trajectory.

The position detection device according to the present invention can be configured such that a plurality of the magnets are disposed along the movement trajectory and the facing surfaces of adjacent magnets among the magnets are magnetized to opposite polarities.

In the position detection device according to the present invention, the movement trajectory is a straight line. Alternatively, the movement trajectory is an arc of a circle.

### Advantageous Effects of Invention

In the present invention, attention is focused on differences in demagnetizing factor for the magnetic flux density of a magnetic field generated by a magnet due to a temperature change between a direction perpendicular to a magnetized surface of the magnet and a direction parallel to the magnetized surface, and the magnetized surface, that is, a surface facing a detection unit, has a shape such that both ends thereof in a direction extending along a relative movement trajectory of the detection unit are positioned more rearward than a center portion thereof. This can reduce the difference in demagnetizing factor due to a temperature change between a component of the magnetic flux density in a direction perpendicular to the movement trajectory and a component of the magnetic flux density in a direction parallel to the movement trajectory and can ensure linearity for detection outputs from the detection unit even if a temperature change occurs.

### Brief Description of Drawings

[Fig. 1] Fig. 1(A) is an explanatory diagram illustrating a position detection device according to a first embodiment of the present invention, and Fig. 1(B) is an explanatory diagram illustrating a conventional position detection device,
[Fig. 2] Fig. 2 is an explanatory diagram illustrating a position detection device according to a second embodiment of the present invention,
[Fig. 3] Figs. 3(A) and 3(B) are explanatory diagrams illustrating position detection devices according to third and fourth embodiments of the present invention,
[Fig. 4] Figs. 4(A), 4(B), and 4(C) are explanatory diagrams of Example 1, Example 2, and Example 3,
[Fig. 5] Figs. 5(A), 5(B), and 5(C) are explanatory diagrams of Comparative Example 1, Comparative Example 2, and Comparative Example 3,
[Fig. 6] Figs. 6(A), 6(B), and 6(C) are charts illustrating variations in the computed value of an arc tangent caused by demagnetization in Example 1, Example 2, and Example 3,
[Fig. 7] Figs. 7(A), 7(B), and 7(C) are charts illustrating variations in the computed value of an arc tangent caused by demagnetization in Comparative Example 1, Comparative Example 2, and Comparative Example 3, and
[Fig. 8] Figs. 8(A), 8(B), 8(C), and 8(D) are charts illustrating variations in the computed value of an arc tangent caused by demagnetization in Example 2A, Example 2B, Example 2C, and Example 2D, which are modifications of Example 2,

### Description of Embodiments

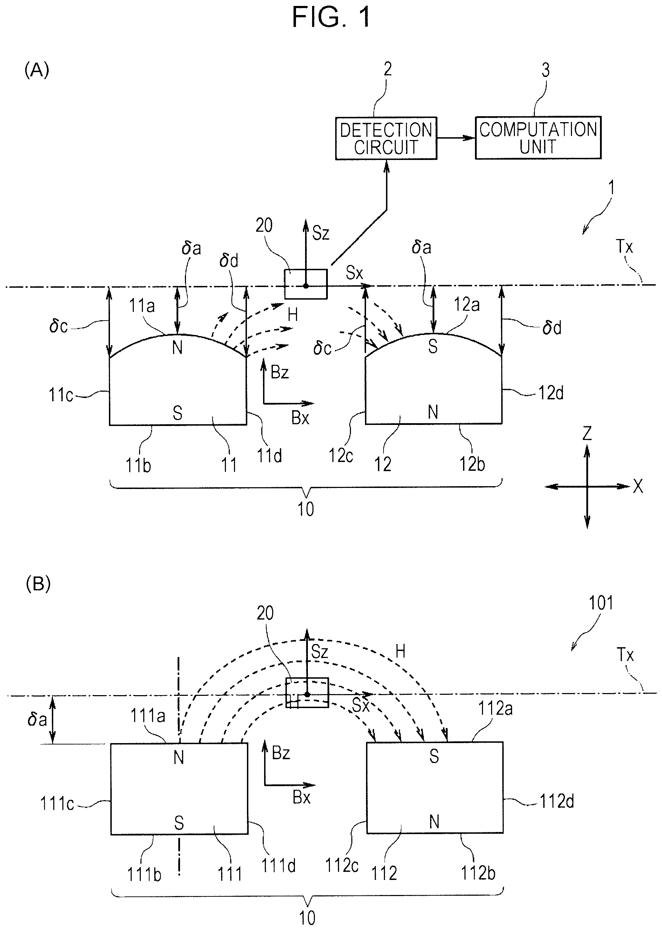

Fig. 1(A) schematically illustrates the structure of a position detection device 1 according to a first embodiment of the present invention.

The position detection device 1 includes a movement unit 10. The movement unit 10 is provided with a movement unit (not illustrated) that linearly reciprocates in the X direction, and a first magnet 11 and a second magnet 12 are mounted on the movement unit. The position detection device 1 is provided with a detection unit 20, and the movement unit 10 and the detection unit 20 face each other in the Z direction.

Since the movement unit 10 moves in the X direction together with the first magnet 11 and the second magnet 12, the relative movement trajectory of the movement unit 10 and the detection unit 20 is indicated by Tx in Fig. 1(A). The position detection device 1 according to the present invention may have a structure in which the first magnet 11 and the second magnet 12 stop, whereas the detection unit 20 moves. In this case, the relative movement trajectory of the magnets 11 and 12 and the detection unit 20 is also Tx.

In Fig. 1(A), the detection unit 20 faces the middle of the first magnet 11 and the second magnet 12 in the X direction, and the first magnet 11 and the second magnet 12 move to the right or left in the X direction from a neutral position illustrated in Fig. 1(A). Alternatively, the movement unit of the movement unit 10 may be urged leftward in the X direction by an urging member such as a compression coil spring and stop at an initial position. When the movement unit is pressed to the right in Fig. 1(A), the magnets 11 and 12 may reciprocate such that they move to the right and then return to the left.

The first magnet 11 has a facing surface 11a that faces the movement trajectory Tx, a rear surface 11b opposite the facing surface 11a, and both side surfaces 11c and 11d that are oriented in the X direction. The facing surface 11a is part of a cylindrical surface having a curvature in the X direction. An opposing distance between the center of the facing surface 11a in the X direction and the movement trajectory Tx is indicated by δa. Further, an opposing distance between an end of the facing surface 11a on the side surface 11c side and the movement trajectory Tx is indicated by δc, and an opposing distance between an end of the facing surface 11a on the side surface 11d side and the movement trajectory Tx is indicated by δd. δc and δd have the same length, and δc and δd are longer than δa. That is, the facing surface 11a has a shape such that both ends thereof in the X direction extending along the movement trajectory Tx are positioned farther away from the movement trajectory Tx than a center portion thereof.

The rear surface 11b of the first magnet 11 is a flat surface that is parallel to the movement trajectory Tx and that is perpendicular to the plane of Fig. 1(A). The side surface 11c and the side surface 11d are flat surfaces that are perpendicular to the movement trajectory Tx and that is perpendicular to the plane of Fig. 1(A).

The first magnet 11 is magnetized in the Z direction, which is a direction perpendicular to the movement trajectory Tx, and the facing surface 11a and the rear surface 11b are magnetized surfaces having opposite polarities. The facing surface 11a is magnetized to the N pole, and the rear surface 11b is magnetized to the S pole.

The first magnet 11 and the second magnet 12 have the same size and shape. The second magnet 12 also has a facing surface 12a, a rear surface 12b, and side surfaces 12c and 12d. The shapes and dimensions of the respective surfaces are the same as those of the first magnet 11. The opposing distances δa, δc, and δd between the facing surface 12a and the movement trajectory Tx are also the same as those of the first magnet 11.

The second magnet 12 is also magnetized in the Z direction, and the facing surface 12a and the rear surface 12b are magnetized surfaces. It is to be noted that the direction of magnetization of the second magnet 12 is reversed to the direction of magnetization of the first magnet 11 by 180 degrees, that is, the facing surface 12a is magnetized to the S pole and the rear surface 12b is magnetized to the N pole.

The detection unit 20 has at least two magnetic sensors. A first magnetic sensor has an axis of sensitivity Sx directed parallel to the movement trajectory Tx and is capable of detecting a magnetic flux density in a direction parallel to the movement trajectory Tx. A second magnetic sensor has an axis of sensitivity Sz directed perpendicular to the movement trajectory Tx and is capable of detecting a magnetic flux density in a direction perpendicular to the movement trajectory Tx. The magnetic sensors are each constituted by a Hall element, a magnetoresistance effect element, or the like.

The outputs from the first magnetic sensor and the second magnetic sensor of the detection unit 20 are detected by a detection circuit 2, and each output is subjected to A/D conversion and is provided to a computation unit 3. The computation unit 3 is constituted by a CPU, a memory, and so on.

Fig. 1(B) illustrates a conventional position detection device 101 for comparison and describing the detection operation of the position detection device 1 according to the present invention.

The position detection device 101 includes a first magnet 111 and a second 112, each of which has a cubic shape, with a facing surface 111a and a facing surface 112a being both flat surfaces that are parallel to the movement trajectory Tx and that are vertical to the plane of Fig. 1(B). A rear surface 111b and a rear surface 112b are flat surfaces that are parallel to the facing surface 111a and the facing surface 112.

Both the first magnet 111 and the second magnet 112 are magnetized in the Z direction. The facing surface 111a of the first magnet 111 is magnetized to the N pole, and the facing surface 112a of the second magnet 112 is magnetized to the S pole. An opposing distance δa between the facing surfaces 111a and 112a and the movement trajectory Tx is the same as the opposing distance δa at the center portions of the facing surfaces 11a and 12a of the magnets 11 and 12 illustrated in Fig. 1(A).

In the position detection device 1 illustrated in Fig. 1(A), a magnetic field H extending from the facing surface 11a of the first magnet 11 to the facing surface 12a of the second magnet 12 is formed. Also in the position detection device 101 illustrated in Fig. 1(B), a magnetic field H extending from the facing surface 111a of the first magnet 111 to the facing surface 112a of the second magnet 112 is formed. In Figs. 1(A) and 1(B), magnetic lines of force that generate the magnetic field H are indicated by broken lines.

When the detection unit 20 relatively moves along the movement trajectory Tx within the magnetic field H, the detection output of the first magnetic sensor having the axis of sensitivity Sx and the detection output of the second magnetic sensor having the axis of sensitivity Sz, which are included in the detection unit 20, exhibit waveforms that are similar to a sine curve and a cosine curve. The computation unit 3 computes an arc tangent from changing outputs that are similar to a sine curve and a cosine curve. The computed value of the arc tangent changes substantially linearly, which enables the measurement of the relative movement positions of the movement unit 10 and the detection unit 20.

It is known that each magnet is subjected to demagnetization in which a generated magnetic field decreases when the temperature of the magnet becomes high. The present invention has been made focusing on a difference between demagnetizing factors for a component (Bx) and a component (Bz) of the magnetic flux density of a magnetic field emerging from a magnet, which occurs when the temperature of the magnet becomes high, with the component (Bx) being directed in the X direction and the component (Bz) being directed in the Z direction. As described below with reference to Examples and Comparative Examples, the difference between the demagnetizing factor for the component (Bx) and the demagnetizing factor for the component (Bz) at a high temperature gradually increases toward either end of each of the facing surfaces 111a and 1112a in the X direction from the center portions thereof.

For this reason, in a high-temperature environment, an error of the calculated value of the arc tangent, which is computed from the ratio of the sine curve and the cosine curve by the computation unit 3, increases as the facing position of the detection unit 20 becomes closer to the vicinity of either end of each of the magnets 111 and 112 rather than the center portion thereof. As a result, the linearity of measured values of the position of the detection unit 20 decreases.

In the position detection device 1 according to an embodiment of the present invention, accordingly, as illustrated in Fig. 1(A), the facing surfaces 11a and 12a of the magnets 11 and 12 each have a shape such that the opposing distances δc and δd between both ends thereof in the X direction and the movement trajectory Tx are longer than the opposing distance δa between the center portion thereof and the movement trajectory Tx.

In the position detection device 1 illustrated in Fig. 1(A), for example, when the detection unit 20 reaches a position facing the front of the side surface 11d of the first magnet 11, the opposing distance δd between the facing surface 11a and the movement trajectory Tx becomes large. As a result, the sensitivity of the component (Bz) of the magnetic flux density in the Z direction, which is detected by the detection unit 20, becomes lower than that when the detection unit 20 faces the center of the facing surface 11a. The rate of decrease of the component (Bz) is greater than the rate of decrease of the sensitivity of the component (Bx) of the magnetic flux density in the X direction when the detection unit 20 faces the front of the side surface 11d.

In addition, the facing surface 11a is an inclined curved surface that gradually inclines away from the movement trajectory Tx toward the side surface 11d from the center portion thereof. Thus, the magnetic field H directed from the facing surface 11a of the first magnet 11 to the facing surface 12a of the second magnet 12 tends to be inclined in the X direction toward the right end of the facing surface 11a. This also makes the rate of decrease of the sensitivity of the component (Bz) of the magnetic flux density in the Z direction greater than the rate of decrease of the sensitivity of the component (Bx) in the X direction when the detection unit 20 faces the front of the side surface 11d.

As a result, when the magnet is subjected to high temperature and the component (Bx) of the magnetic flux density in the X direction in front of the side surface 11d attenuates, the component (Bz) of the magnetic flux density in the Z direction, which is detected by the detection unit 20, can be decreased accordingly in accordance with the shape of the facing surface 11a. Thus, the calculated value of the arc tangent, which is computed on the basis of the ratio of the detection output of the first magnetic sensor having the axis of sensitivity Sx and the detection output of the second magnetic sensor having the axis of sensitivity Sz, which are detected by the detection unit 20, can maintain linearity when the detection unit 20 faces the center portion of each of the facing surfaces 11a and 12a in the X direction and when the detection unit 20 faces either end of each of the facing surfaces 11a and 12a in the X direction.

To this end, the facing surfaces 11a and 12a of the magnets 11 and 12 need to be gradually inclined such that both ends thereof in the X direction are farther away from the movement trajectory Tx than the center portions thereof. In addition, each of the facing surfaces 11a and 12a is formed to be a projecting curved surface, which allows the rate of attenuation of the component (Bx) of the magnetic flux density in the X direction that attenuates in a high-temperature environment to easily match the rate of attenuation of the component (Bz) in the Z direction toward either end thereof.

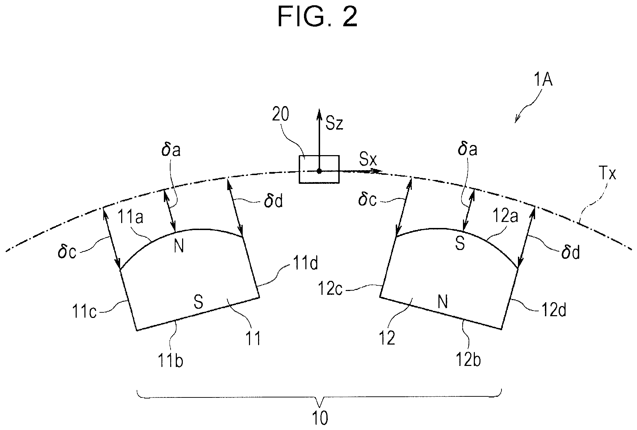

Fig. 2 illustrates a position detection device 1A according to a second embodiment of the present invention.

A first magnet 11 and a second magnet 12 that are used in the position detection device 1A are the same as those in the position detection device 1 illustrated in Fig. 1(A). In the position detection device 1A illustrated in Fig. 2, a movement unit 10 having the magnets 11 and 12 rotates, and a relative movement trajectory Tx of the movement unit 10 and a detection unit 20 extends along an arc of a circle. Also in the position detection device 1A, the magnets 11 and 12 may be fixed and the detection unit 20 may move along the arc-shaped movement trajectory Tx.

In the position detection device 1A illustrated in Fig. 2, the opposing distances δc and δd between both ends of each of the respective facing surfaces 11a and 12a of the magnets 11 and 12 along the arc-shaped movement trajectory and the movement trajectory Tx are longer than the opposing distance δa between the center portion thereof and the movement trajectory Tx. Also in this embodiment, in a high-temperature environment, the difference in the rate of decrease between the detection output in a direction extending along the movement trajectory Tx and the detection output in a direction perpendicular to the movement trajectory Tx can be reduced and linearity can be maintained.

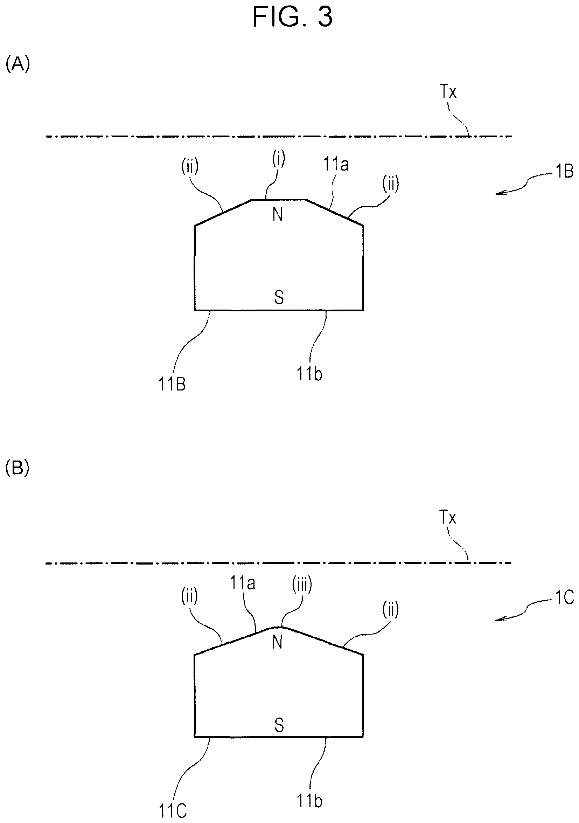

Fig. 3(A) illustrates a position detection device 1B according to a third embodiment of the present invention. A magnet 11B used in the position detection device 1B has a facing surface 11a that is constituted by a flat portion (i) in a center portion thereof, which is parallel to the movement trajectory Tx, and inclined flat portions (ii) on both sides of the flat portion (i).

Fig. 3(B) illustrates a position detection device 1C according to a fourth embodiment of the present invention. A magnet 11C used in the position detection device 1C has a facing surface 11a that is constituted by a projecting curved surface portion (iii) in a center portion thereof and inclined flat portions (ii) on both sides of the projecting curved surface portion (iii).

Also in the position detection devices 1B and 1C, when the detection unit 20 relatively moves along the movement trajectory Tx, the linearity error for detection outputs can be reduced.

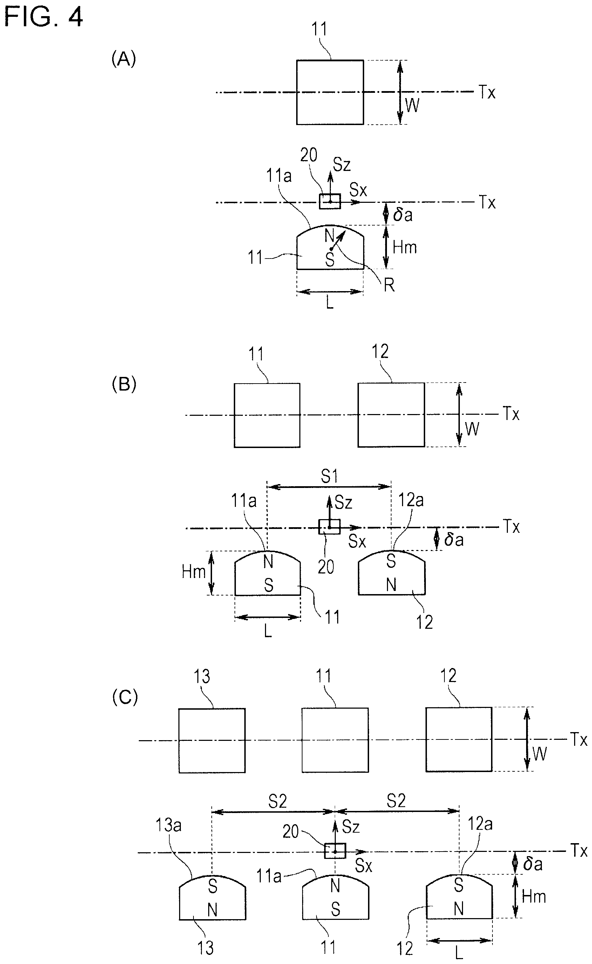

A position detection device according to the present invention may include only one magnet, as illustrated in Fig. 4(A), or three or more magnets, as illustrated in Fig. 4(C).

### EXAMPLES

Fig. 4(A) illustrates Example 1, in which a single magnet 11 faces the relative movement trajectory Tx of the detection unit 20. Fig. 4(B) illustrates Example 2, in which two magnets 11 and 12 face the relative movement trajectory Tx of the detection unit 20. Fig. 4(C) illustrates Example 3, in which three magnets 11, 12, and 13 face the relative movement trajectory Tx of the detection unit 20.

The magnets 11, 12, and 13 have facing surfaces 11a, 12a, and 13a that are projecting curved surfaces having curvatures in a direction extending along the movement trajectory Tx, with their radii of curvature being indicated by R.

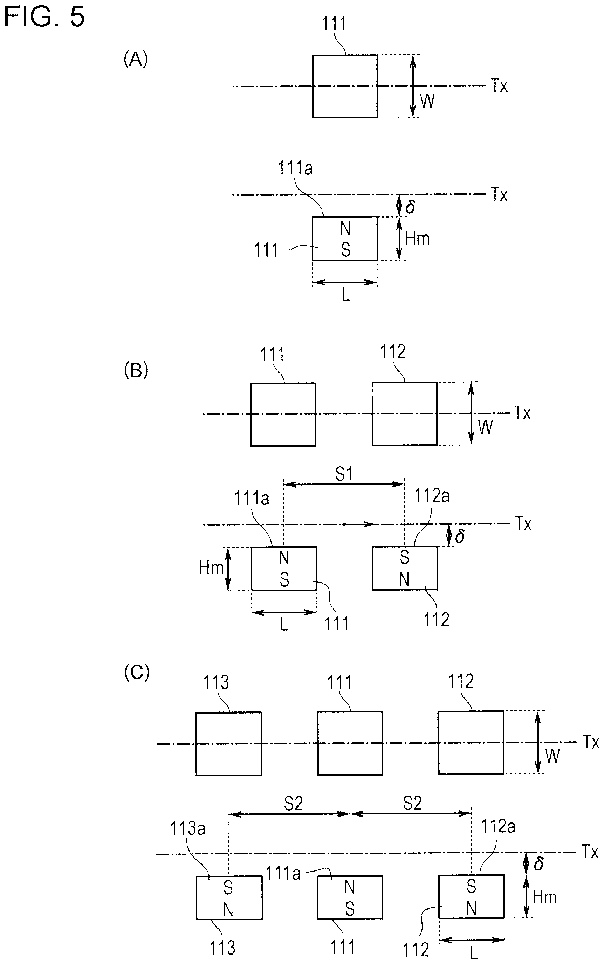

Fig. 5(A) illustrates Comparative Example 1, in which a single magnet 111 faces the relative movement trajectory Tx of the detection unit 20. Fig. 5(B) illustrates Comparative Example 2, in which two magnets 111 and 112 face the relative movement trajectory Tx of the detection unit 20. Fig. 5(C) illustrates Comparative Example 3, in which three magnets 111, 112, and 113 face the relative movement trajectory Tx of the detection unit 20.

The magnets 111, 112, and 113 have facing surfaces 111a, 112a, and 113a that are all flat surfaces.

The magnets 11, 12, and 13 in Examples and the magnets 111, 112, and 113 in Comparative Examples are each a rare-earth based (Nd-Fe-B based) injection molded magnet.

The magnets 11, 12, and 13 in Examples and the magnets 111, 112, and 113 in Comparative Examples each have dimensions such that a height Hm is 6 mm, a length L in a direction extending along the movement trajectory Tx is 9 mm, and a width W in a direction perpendicular to the movement trajectory Tx is 9 mm. The facing surfaces 11a, 12a, and 13a of the magnets 11, 12, and 13 have a radius of curvature R of 9 mm. The opposing distance δa between the center portions of the facing surfaces of the magnets 11, 12, and 13 in Examples and the movement trajectory Tx and the opposing distance δa between the respective facing surfaces of the magnets 111, 112, and 113 in Comparative Examples and the movement trajectory Tx, that is, the shortest value of the opposing distance between each magnet and the movement trajectory Tx, are each 3.55 mm.

In Example 2 in Fig. 4(B) and Comparative Example 2 in Fig. 5(B), an inter-magnet distance S1 is 17 mm, and in Example 3 in Fig. 4(C) and Comparative Example 3 in Fig. 5(C), an inter-magnet distance S2 is 18 mm.

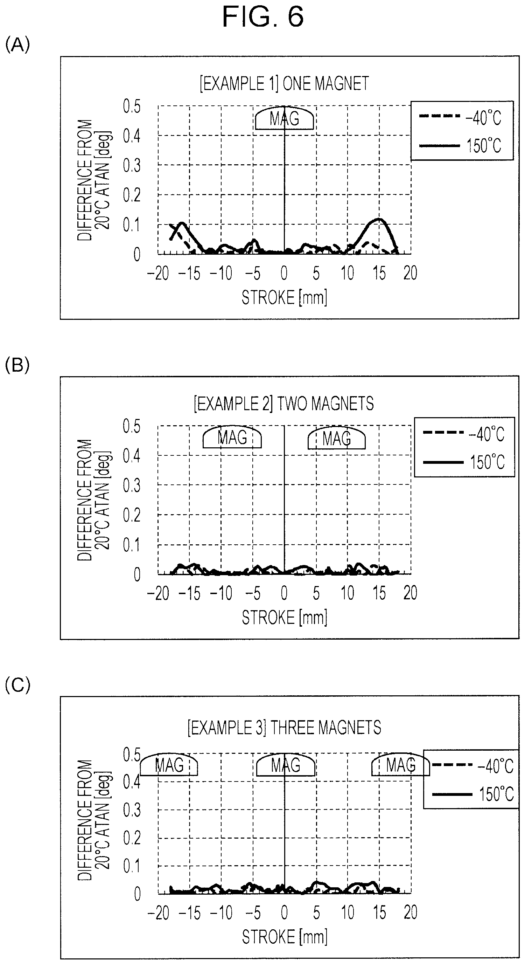

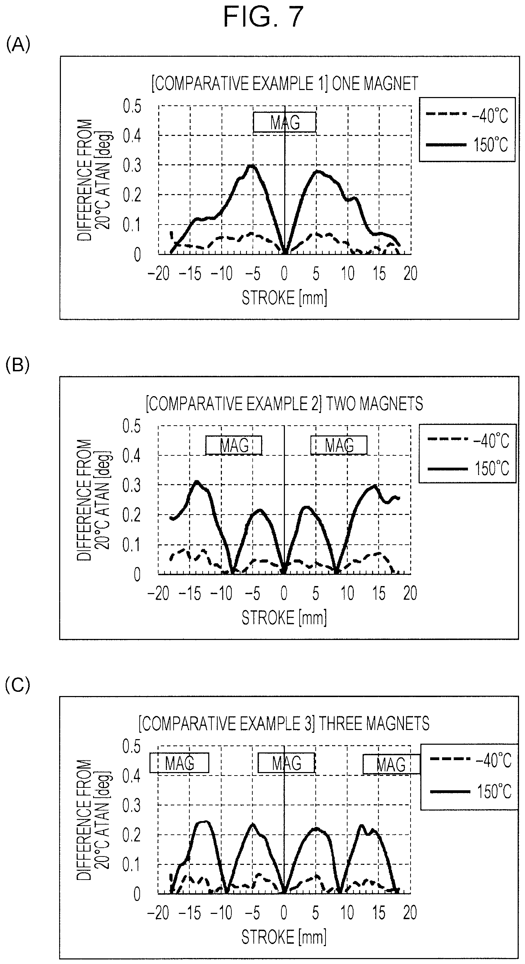

Figs. 6(A), 6(B), and 6(C) illustrate the moving position of the detection unit 20 and the linearity error for outputs of the detection unit 20 in the respective Examples. Figs. 7(A), 7(B), and 7(C) illustrate the moving position of the detection unit 20 and the linearity error for outputs of the detection unit 20 in the respective Comparative Examples.

In Fig. 6 and Fig. 7, the horizontal axis represents the relative positions of each magnet and the detection unit 20 along the movement trajectory Tx.

Fig. 6(A) illustrates simulation results of Example 1, and the origin "0" of the horizontal axis indicates that, as illustrated in Fig. 4(A), the detection unit 20 is positioned to face the center of the magnet 11. Fig. 6(B) illustrates measurement results of Example 2, and the origin "0" of the horizontal axis indicates that, as illustrated in Fig. 4(B), the detection unit 20 is positioned in the middle of the two magnets 11 and 12. Fig. 6(C) illustrates measurement results of Example 3, and the origin "0" of the horizontal axis indicates that, as illustrated in Fig. 4(C), the detection unit 20 is positioned to face the center of the middle magnet 11.

Fig. 7(A) illustrates measurement results of Comparative Example 1, and the origin "0" of the horizontal axis indicates that, as illustrated in Fig. 5(A), the detection unit 20 is positioned to face the center of the magnet 111. Fig. 7(B) illustrates measurement results of Comparative Example 2, and the origin "0" of the horizontal axis indicates that, as illustrated in Fig. 5(B), the detection unit 20 is positioned in the middle of the two magnets 111 and 112. Fig. 7(C) illustrates measurement results of Comparative Example 3, and the origin "0" of the horizontal axis indicates that, as illustrated in Fig. 5(C), the detection unit 20 is positioned to face the center of the middle magnet 111.

In Figs. 6(A), 6(B), and 6(C) and Figs. 7(A), 7(B), and 7(C), the characteristics at an environmental temperature of 150 °C are indicated by solid lines, and the characteristics at an environmental temperature of -40 °C are indicated by broken lines.

In Fig. 6 and Fig. 7, the vertical axis represents an error of the calculated value of the arc tangent (ATAN) computed on the basis of the detection output of the first magnetic sensor having the axis of sensitivity Sx and the detection output of the second magnetic sensor having the axis of sensitivity Sz, which are included in the detection unit 20. That is, the difference (deg) between the calculated value of the arc tangent (ATAN) at a room temperature of 20 °C and the calculated value of the arc tangent (ATAN) at 150 °C is indicated by a solid line, and the difference (deg) between the calculated value of the arc tangent (ATAN) at a room temperature of 20 °C and the calculated value of the arc tangent (ATAN) at -40 °C is indicated by a broken line.

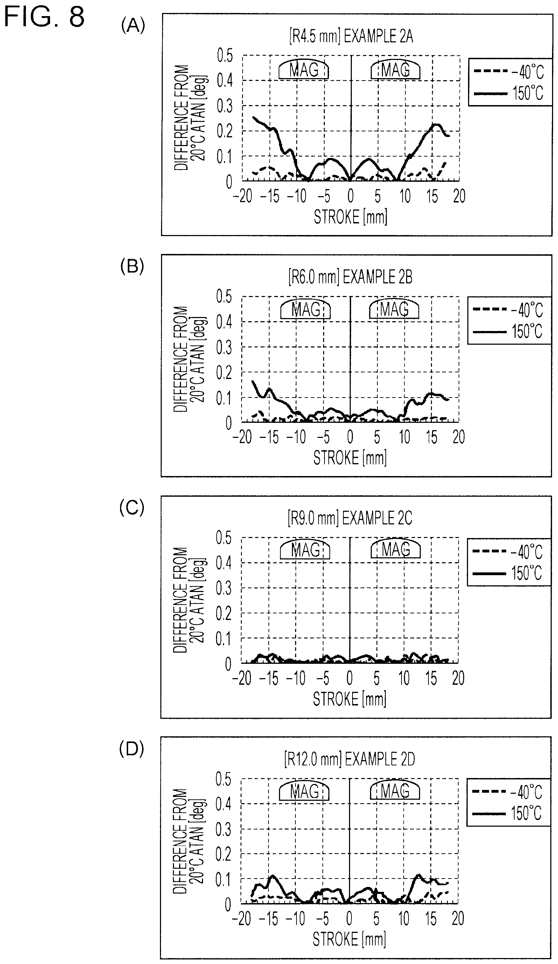

In the respective Comparative Examples in Fig. 7, it is seen that, in a high-temperature environment, the error of the calculated value of the arc tangent is large when the detection unit 20 faces either end of a magnet, which results in linearity of position detection being impaired. In contrast, in the respective Examples in Fig. 8, it is seen that an error can be suppressed and linearity is improved.

In Fig. 6(A) and Fig. 7(A), it is assumed that the amount of relative movement of the detection unit 20 is in a range of ±3.5 mm. In this case, in Comparative Example 1 illustrated in Fig. 7(A), the difference (deg) in the calculated value (ATAN) is 0.24 deg, whereas in Example 1 illustrated in Fig. 6(A), the difference (deg) in the calculated value (ATAN) is about 0.03 deg.

In Fig. 6(B) and Fig. 7(B), it is assumed that the amount of relative movement of the detection unit 20 is in a range of ±7.5 mm. In this case, in Comparative Example 2 illustrated in Fig. 7(B), the difference (deg) in the calculated value (ATAN) is 0.21 deg, whereas in Example 2 illustrated in Fig. 7(B), the difference (deg) in the calculated value (ATAN) is 0.06 deg.

In Fig. 6(C) and Fig. 7(C), it is assumed that the amount of relative movement of the detection unit 20 is in a range of ±17 mm. In this case, in Comparative Example 3 illustrated in Fig. 7(C), the difference (deg) in the calculated value (ATAN) is 0.25 deg, whereas in Example 3 illustrated in Fig. 6(C), the difference (deg) in the calculated value (ATAN) is 0.07 deg.

Fig. 8 illustrates simulation results for Examples 2A, 2B, 2C, and 2D, which are modifications of Example 2 illustrated in Fig. 4(B). Each magnet has a facing surface with its radius of curvature R being 4.5 mm in Example 2A in Fig. 8(A), being 6.0 mm in Example 2B in Fig. 8(B), being 9.0 mm in Example 2C in Fig. (C), and being 12 mm in Example 2D in Fig. 8(D).

In Examples 2A, 2B, 2C, and 2D, linearity of calculated values of the arc tangent is improved, compared with Comparative Example 2 illustrated in Fig. 7. It is to be noted that the effect of improving linearity of calculated values is very high when R is from the range of 6.0 mm to the range of 12 mm. Since the distance between the facing surface of each magnet and the movement trajectory Tx is 3.55 mm, the R/δa ratio is preferably in a range greater than or equal to 1.7 and less than or equal to 3.4.

### Reference Signs List

- 1, 1A, 1B, 1C: position detection device
- 10: movement unit
- 11: first magnet
- 11a: facing surface
- 12: second magnet
- 12a: facing surface
- 13: magnet
- 13a: facing surface
- 20: detection unit
- 111, 112, 113: magnet
- 111a, 112a, 113a: facing surface

## Claims

1. A position detection device (1) comprising a detection unit (20) and a magnet (11, 12) facing the detection unit (20), the detection unit (20) and the magnet (11, 12) being movable relatively to each other,
wherein the magnet (11, 12) is magnetized in a direction perpendicular to a relative movement trajectory (Tx) of the detection unit (20), and the detection unit (20) includes a magnetic sensor that detects a component of magnetic flux emerging from the magnet (11, 12) that is parallel to the movement trajectory (Tx), and a magnetic sensor that detects a component of the magnetic flux that is perpendicular to the movement trajectory (Tx), and
wherein the magnet (11, 12) has a facing surface (11a, 12a) facing the movement trajectory (Tx), and, when seen in a cross-sectional representation comprising the movement trajectory (Tx), a distance between the movement trajectory (Tx) and each of both ends of the facing surface (11a, 12a) in a direction extending along the movement trajectory (Tx) is longer than a distance between the movement trajectory (Tx) and a center portion of the facing surface (11a, 12a),
**characterised in that**
a plurality of the magnets (11, 12) are disposed along the movement trajectory (Tx), and the facing surfaces (11a, 12a) of adjacent magnets (11, 12) among the magnets (11, 12) are magnetized to opposite polarities.

2. The position detection device according to Claim 1, wherein, when seen in the cross-sectional representation comprising the movement trajectory (Tx), the facing surface is a projecting curved surface having a curvature in a direction extending along the movement trajectory (Tx).

3. The position detection device according to Claim 2, wherein the curvature has a radius that is greater than or equal to 1.7 times and less than or equal to 3.4 times a shortest distance between the facing surface and the movement trajectory (Tx).

4. The position detection device according to any one of Claims 1 to 3, wherein the movement trajectory (Tx) is a straight line.

5. The position detection device according to any one of Claims 1 to 3, wherein the movement trajectory (Tx) is an arc of a circle.

## Patentansprüche

1. Positionserfassungsvorrichtung (1), die eine Erfassungseinheit (20) und einen der Erfassungseinheit (20) zugewandten Magneten (11, 12) aufweist, wobei die Erfassungseinheit (20) und der Magnet (11, 12) relativ zueinander beweglich sind,
wobei der Magnet (11, 12) in einer Richtung rechtwinklig zu einer Relativbe - wegungsbahn (Tx) der Erfassungseinheit (20) magnetisiert ist und die Erfassungseinheit (20) einen Magnetsensor beinhaltet, der eine Komponente des aus dem Magneten (11, 12) austretenden Magnetflusses erfasst, die parallel zu der Bewegungsbahn (Tx) ist, sowie einen Magnetsensor beinhal - tet, der eine zu der Bewegungsbahn (Tx) rechtwinklige Komponente des Magnetflusses erfasst, und
wobei der Magnet (11, 12) eine zugewandte Fläche (11a, 12a) aufweist, die der Bewegungsbahn (Tx) zugewandt ist, und wobei bei Betrachtung in einer die Bewegungsbahn (Tx) beinhaltenden Querschnittsdarstellung eine Di - stanz zwischen der Bewegungsbahn (Tx) und jedem der beiden Enden der zugewandten Fläche (11a, 12a) in einer entlang der Bewegungsbahn (Tx) verlaufenden Richtung länger ist als eine Distanz zwischen der Bewegungs - bahn (Tx) und einem zentralen Bereich der zugewandten Fläche (11a, 12a), **dadurch gekennzeichnet,**
**dass** eine Mehrzahl von Magneten (11, 12) entlang der Bewegungsbahn (Tx) angeordnet ist und die zugewandten Flächen (11a, 12a) von benach - barten Magneten (11, 12) unter den Magneten (11, 12) auf entgegengesetz - te Polaritäten magnetisiert sind.

2. Positionserfassungsvorrichtung nach Anspruch 1,
wobei bei Betrachtung in der die Bewegungsbahn (Tx) beinhaltenden Quer - schnittsdarstellung die zugewandte Fläche eine vorstehende gekrümmte Fläche mit einer Krümmung in einer Richtung ist, die sich entlang der Bewe - gungsbahn (Tx) erstreckt.

3. Positionserfassungsvorrichtung nach Anspruch 2,
wobei die Krümmung einen Radius aufweist, der größer als oder gleich dem 1,7-fachen und geringer als oder gleich dem 3,4-fachen einer kürzesten Di - stanz zwischen der zugewandten Fläche und der Bewegungsbahn (Tx) ist.

4. Positionserfassungsvorrichtung nach einem der Ansprüche 1 bis 3,
wobei die Bewegungsbahn (Tx) eine gerade Linie ist.

5. Positionserfassungsvorrichtung nach einem der Ansprüche 1 bis 3,
wobei die Bewegungsbahn (Tx) ein Kreisbogen ist.

## Revendications

1. Dispositif de détection d'une position (1) comprenant une unité de détection (20) et un aimant (11, 12) qui est disposé à l'opposé de l'unité de détection (20), l'unité de détection (20) et l'aimant (11, 12) étant mobiles l'un par rapport à l'autre ;
dans lequel l'aimant (11, 12) est magnétisé dans une direction qui est perpendiculaire à une trajectoire de mouvement relatif (Tx) de l'unité de détection (20), et l'unité de détection (20) englobe un capteur magnétique qui détecte une composante d'un flux magnétique émanant de l'aimant (11, 12), qui est parallèle à la trajectoire de mouvement (Tx), et un capteur magnétique qui détecte une composante du flux magnétique, qui est perpendiculaire à la trajectoire de mouvement (Tx) ; et
dans lequel l'aimant (11, 12) possède une surface orientée (11a, 12a), orientée sur la trajectoire de mouvement (Tx) ; et, lorsqu'on regarde dans une vue en coupe transversale qui comprend la trajectoire de mouvement (Tx), une distance entre la trajectoire de mouvement (Tx) et chacune des deux extrémités de la surface orientée (11a, 12a) dans une direction qui s'étend le long de la trajectoire de mouvement (Tx) est plus longue qu'une distance qui s'étend entre la trajectoire de mouvement (Tx) et une portion centrale de la surface orientée (11a, 12a) ;
**caractérisé en ce que**
un certain nombre des aimants (11, 12) sont disposés le long de la trajectoire de mouvement (Tx) et les surfaces orientées (11a, 12a) d'aimants adjacents (11, 12) parmi les aimants (11, 12) sont magnétisées à des polarités opposées.

2. Dispositif de détection d'une position selon la revendication 1, dans lequel, lorsqu'on regarde dans une vue en coupe transversale qui comprend la trajectoire de mouvement (Tx), la surface orientée représente une surface courbe faisant saillie dont la courbure se dessine dans une direction qui s'étend le long de la trajectoire de mouvement (Tx).

3. Dispositif de détection d'une position selon la revendication 2, dans lequel la courbure possède un rayon qui est supérieur ou égal à 1,7 fois et qui est inférieur ou égal à 3,4 fois une distance la plus courte s'étendant entre la surface orientée et la trajectoire de mouvement (Tx).

4. Dispositif de détection d'une position selon l'une quelconque des revendications 1 à 3, dans lequel la trajectoire de mouvement (Tx) est une ligne droite.

5. Dispositif de détection d'une position selon l'une quelconque des revendications 1 à 3, dans lequel la trajectoire de mouvement (Tx) est un arc de cercle.
